# EUROPÄISCHE PATENTSCHRIFT

(11) **EP 1 254 518 B1**
(45) Veröffentlichungstag und Bekanntmachung des Hinweises auf die Patenterteilung: **16.06.2004**
(21) Anmeldenummer: 00909155.4
(22) Anmeldetag: 11.02.2000
(51) Int. Cl.: H03M 1/18

(54) **VERFAHREN ZUM UMWANDELN EINES ANALOGEN SIGNALS IN EIN DIGITALES SIGNAL**
METHOD FOR CONVERTING AN ANALOGOUS SIGNAL INTO A DIGITAL SIGNAL
PROCEDE DE TRANSFORMATION D'UN SIGNAL ANALOGIQUE EN SIGNAL NUMERIQUE

(43) Veröffentlichungstag der Anmeldung: 06.11.2002
(73) Patentinhaber: Georg Neumann GmbH, 13403 Berlin (DE)
(72) Erfinder: KERN, Otmar, D-14167 Berlin (DE)
(74) Vertreter: Konle, Tilmar, Dipl.-Ing.
(86) Internationale Anmeldenummer: PCT/EP2000/001133
(87) Internationale Veröffentlichungsnummer: WO 2001/059932

(56) Entgegenhaltungen:
- EP-A- 0 431 214
- EP-A- 0 475 376

## Beschreibung

Die Erfindung bezieht sich auf ein Verfahren gemäß dem Oberbegriff des Patentanspruchs 1. Ein derartiges Verfahren ist allgemein bekannt.

Zur hochauflösenden Umwandlung analoger Nutzsignale, vor allem im Audiobereich, werden vorzugsweise sogenannte Delta-Sigma-Wandler verwendet, bei denen mit einer sehr hohen Taktfrequenz in einem Modulator-Regelkreis ein Datenstrom erzeugt wird, wobei die analoge Information durch den Flächeninhalt der digitalen Zustände des digitalen Ausgangssignals repräsentiert wird. Die digitale Information wird daher zunächst in der Zeitebene erhalten, wobei die erreichbare Auflösung des Nutzsignals eine Funktion der Taktfrequenz darstellt. Die Taktfrequenz kann jedoch nicht beliebig hoch gewählt werden, da die Ungenauigkeiten der Taktflanken in Form von Jitter und Flankenrauschen direkt in die Nutzinformation eingehen. Unter Ausnutzung der derzeit verfügbaren Technologien werden bei Delta-Sigma-Wandlern eine Auflösung von 24 Bit und eine Dynamik (Signalabstand zwischen Rauschen und Vollaussteuerung) von ca. 117 dB (A-weighted) erzielt. Diese Werte liegen jedoch um etwa 15 bis 25 dB unterhalb der Dynamikdaten, welche im Bereich professioneller Audiosignalverarbeitung benötigt werden.

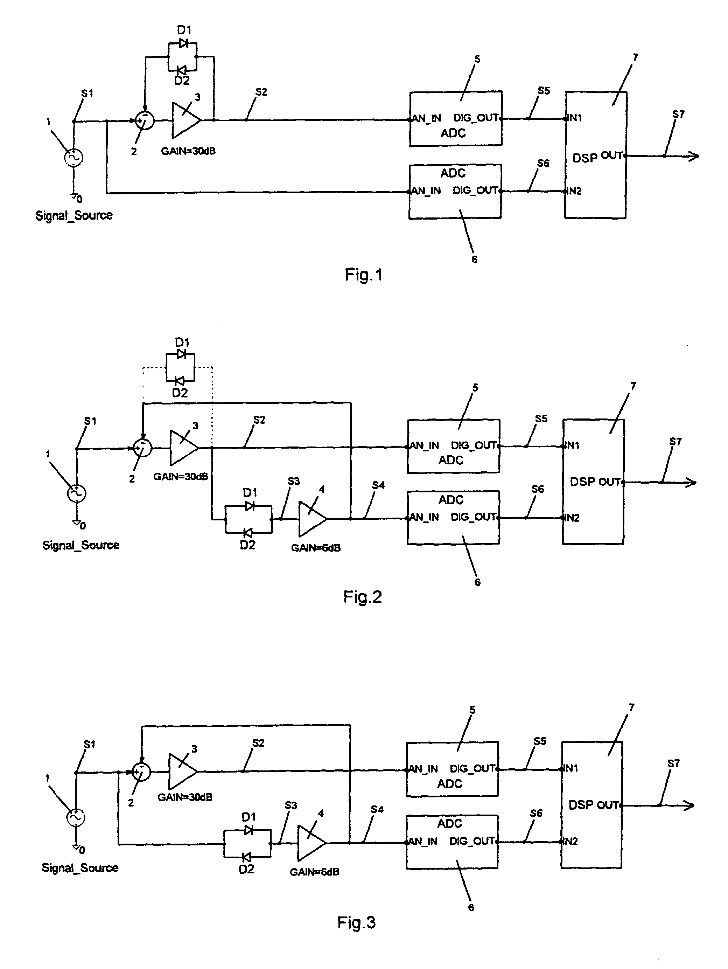

Zur Erhöhung des Dynamikumfangs bei der Analog-Digital-Wandlung ist es allgemein bekannt, den zu beherrschenden Dynamikbereich in mehrere, vorzugsweise in zwei Teilbereiche aufzuteilen, wie anhand von Fig. 1 veranschaulicht ist. Wie aus Fig. 1 hervorgeht, wird das Eingangssignal S1 in einem ersten Signalweg über einen Addierer 2 an einen Verstärker 3 geschaltet, in welchem kleinpegelige Signale analog verstärkt werden, beispielsweise um +30 dB. Das verstärkte Signal S2 wird im ersten Signalweg einem Analog-Digital-Wandler 5 zugeführt. Das Eingangssignal S1 wird ferner in einem zweiten Signalweg unverstärkt einem zweiten Analog-Digital-Wandler 6 zugeführt. Die beiden digitalisierten Signale S5 und S6 des ersten und zweiten Signalweges werden zur weiteren Signalverarbeitung einem digitalen Signalprozessor 7 zugeführt, an dessen Ausgang das fertige digitale Ausgangssignal S7 durch Zusammensetzen der Signale S5 und S6 entsteht.

Bei kleinen Signalamplituden, welche im ersten Signalweg den Verstärker 3 bzw. den Analog-Digital-Wandler 5 nicht übersteuern, wird zur Erzeugung des Ausgangssignals S7 das digitale Signal S5 mit Hilfe des digitalen Signalprozessors 7 um die Verstärkung des Verstärkers 3 vermindert, was zur betragsmäßig gleichen Minderung des digitalen Rauschens aus dem Analog-Digital-Wandler 5 führt. Das um die Verstärkung des Verstärkers 3 verminderte digitale Signal S5 wird dann als Ausgangssignal S7 von dem digitalen Signalprozessor 7 durchgeschaltet, wohingegen das digitale Signal S6 am Ausgang des Analog-Digital-Wandlers 6 durch den digitalen Signalprozessor 7 abgeschaltet bleibt.

Bei größeren Signalamplituden, welche der erste Analog-Digital-Wandler 5 nicht mehr verarbeiten kann, wird dessen digitales Ausgangssignal S5 mittels des digitalen Signalprozessors 7 abgeschaltet bzw. ausgeblendet, wohingegen das digitale Ausgangssignal S6 des Analog-Digital-Wandlers 6, welches aus dem unverstärkten Eingangssignal S1 gewonnen wird, von dem digitalen Signalprozessor 7 als Ausgangssignal S7 benutzt wird.

Des weiteren kann zur Vermeidung von unerwünschten Übersteuerungen des Verstärkers 3 in den Gegenkopplungsweg des Verstärkers 3 ein nicht-lineares Netzwerk, beispielsweise in Form antiparallel geschalteter Dioden D1, D2, geschaltet werden, wodurch die Verstärkung des Verstärkers 3 für den Fall großer Signalamplituden, die den Aussteuerbereich des Analog-Digital-Wandlers 5 übersteigen und dort begrenzt werden, vermindert wird.
Das an Hand von Fig. 1 erläuterte Verfahren ist in der Fachwelt unter dem Begriff "Gain Staging" bekannt, das u.a. folgende Nachteile aufweist:
- Die Auflösung der Nutzinformation im digitalen Ausgangssignal S7 am Umschaltpunkt bei der Übernahme der digitalisierten Signale S5, S6 aus dem ersten oder zweiten Signalweg ändert sich schlagartig, wobei der Umschaltpunkt typischerweise mitten im Bereich der Arbeitsdynamik des Nutzsignals liegt. Diese schlagartige Auflösungsänderung wirkt sich vor allem auf Audioprogrammsignale aus, bei denen gleichzeitig Töne mit großen und sehr kleinen Pegeln auftreten.
- Die rechtzeitige Erkennung des Umschaltpunktes aus dem sich ändernden digitalisierten Nutzsignal, speziell bei höherfrequenten Signalanteilen, ist schon wegen der extremen prinzipbedingten Bandbreitenbegrenzung von Analog-Digital-Wandlern problematisch.
- Die Abgleichgenauigkeit hinsichtlich Verstärkung und Zeitverhalten zwischen der komplementär wirkenden analogen und digitalen Signalverarbeitung muß zur Vermeidung von Verzerrungen extrem hoch sein.
- Die gezielte Übersteuerung des Verstärkers 3 im ersten Signalweg stellt hohe Anforderungen. Sie muß völlig verzögerungsfrei arbeiten, was vor allem beim Übergang vom übersteuerten in den normalen Betriebszustand kritisch ist.
- Selbst wenn die gezielte Übersteuerung des Verstärkers 3 im ersten Signalweg völlig einwandfrei funktioniert, sind Fehler im Augenblick des Umschaltens von dem Signal S6 auf das Signal S5 nicht zu vermeiden, weil das im Analog-Digital-Wandler 5 enthaltene digitale Dezimierungsfilter nach einer Übersteuerung des Analog-Digital-Wandlers 5 fehlerhafte Daten enthält und sich erst nach einer typischen Durchlaufzeit im Bereich zwischen 0,5 und 1 ms wieder einwandfrei arbeitet.

Die Aufgabe der Erfindung besteht demgegenüber darin, bei einem Verfahren der eingangs genannten Art eine schlagartige Veränderung der Signalauflösung und Schaltvorgänge im Nutzsignal zu vermeiden. Ferner wird angestrebt, eine bessere Ausnutzung der beiden Signalwege mit der Wirkung höherer bzw. maximal möglicher Signalauflösung bei größeren Signalamplituden und somit erhöhtem Dynamikumfang zu erzielen und gleichzeitig eine unkritische und in der digitalen Nachbearbeitung einfache und fehlerfreie Signalverarbeitung zu ermöglichen.

Die Aufgabe wird erfindungsgemäß durch die kennzeichnenden Merkmale des Anspruchs 1 gelöst.

Vorteilhafte Ausgestaltung und Weiterbildungen des erfindungsgemäßen Verfahrens nach Anspruch 1 ergeben sich aus den Unteransprüchen.

Die Erfindung wird anhand eines in den Zeichnungen dargestellten Ausführungsbeispiels näher erläutert. Es zeigt:
- Fig. 2,3: Schaltbilder von Ausführungsbeispielen einer Schaltungsanordnung zur Durchführung des erfindungsgemäßen Verfahrens,
- Fig. 4: Signalverläufe von komplementär verzerrten Signalen im ersten und zweiten Signalweg der Schaltungsanordnung nach Fig. 2 bzw. 3, und
- Fig. 5: ein Schaltbild einer weiteren Variante einer Schaltungsanordnung zur Durchführung des erfindungsgemäßen Verfahrens.

Bei der Schaltungsanordnung nach Fig. 2 zur Durchführung des erfindungsgemäßen Verfahrens sind in gleicher Weise wie bei der Schaltungsanordnung nach Fig. 1 ein erster und ein zweiter Signalweg vorgesehen, wobei der erste Signalweg in gleicher Weise wie bei der Schaltungsanordnung nach Fig. 1 aufgebaut ist, d.h., einen Addierer 2, einen Verstärker 3 und einen Analog-Digital-Wandler 5 enthält. Ferner enthält auch der zweite Signalweg einen Analog-Digital-Wandler 6, wobei die digitalisierten Ausgangssignale S5 und S6 des ersten Analog-Digital-Wandlers 5 und des zweiten Analog-Digital-Wandlers 6 einem digitalen Signalprozessor 7 zugeführt werden, welcher das gewünschte digitale Ausgangssignal S7 erzeugt. Der Verstärker 3 im ersten Signalweg dient ebenfalls dazu, kleine, noch darzustellende Signalanteile über den Rauschteppich des ersten Analog-Digital-Wandlers 5 anzuheben, wobei Signalanteile, welche den Analog-Digital-Wandler 5 übersteuern würden, bereits vorher mit Hilfe eines nicht-linearen Netzwerks D1, D2 im Gegenkopplungszweig des Verstärkers 3 mit zunehmender Amplitude weniger verstärkt werden. Infolge der nicht-linearen Gegenkopplung weist das Ausgangssignal S2 des Verstärkers 3 oberhalb einer bestimmten Signalamplitude eine verzerrte Signalform auf, welche den logarithmischen Kennlinien der antiparallel geschalteten Dioden D1 D2 im Gegenkopplungszweig folgt.

Der Grundgedanke des in der Schaltungsanordnung nach Fig. 2 verwirklichten Verfahrens nach der Erfindung besteht darin, daß das begrenzte bzw. verzerrte Signal S2 am Ausgang des Verstärkers 3 so betrachtet wird, als sei es durch die lineare Zusammenschaltung bzw. Addition zweier Signale im Addierer 2 entstanden, nämlich durch das lineare Eingangssignal S1 und eines verzerrten Signals S4, so daß das resultierende Signal S2 eine bezüglich des verzerrten Signals S4 komplementär verzerrte Signalform erhält. Das verzerrte Signal S4 wird in noch zu beschreibender Weise im zweiten Signalweg erzeugt und dem dortigen Analog-Digital-Wandler 6 zugeführt. Der digitale Signalprozessor 7 erhält somit zwei komplementär verzerrte digitale Signal S5 und S6, welche vorzeichenrichtig und amplitudenrichtig, d.h., im Verhältnis der gewählten Verstärkung des Verstärkers 3, im digitalen Signalprozessor 7 zusammengesetzt werden. Im Ergebnis erhält man ein am Ausgang des Signalprozessors 7 ein unverzerrtes digitales Ausgangssignal S7. Es versteht sich, daß der digitale Signalprozessor 7 durch beliebige, gleichwirkende digitale Schaltungsanordnungen ersetzt werden kann.

Zur Erzeugung des verzerrten Signals S4 sind in dem Beispielsfall nach Fig. 2 in dem zweiten Signalweg die beiden antiparallel geschalteten Dioden D1 und D2 vorgesehen, denen in gleicher Weise wie den antiparallel geschalteten Dioden D1 und D2 im Gegenkopplungszweig des Verstärkers 3 das verstärkte Signal S2 am Ausgang des Verstärkers 3 zugeführt wird. Das durch die antiparallel geschalteten Dioden D1, D2 im zweiten Signalweg verzerrte Signal S3 wird auf den Eingang eines Verstärkers 4 geschaltet, welcher an seinem Ausgang das verzerrte Signal S4 erzeugt. Das verzerrte Signal S4 wird, wie schon erwähnt, sowohl dem Analog-Digital-Wandler 6 als auch dem Addierer 2 im ersten Signalweg zugeführt. Die Addition des verzerrten Signals S4 im Addierer 2 zum linearen Eingangssignal S1 erfolgt linear und vorzeichenrichtig im Sinne einer Gegenkopplung. Im Ergebnis wird durch die Gegenkopplung des verzerrten Signals S4 ein geschlossener Regelkreis gebildet, durch welchen sich automatisch die komplementär bezüglich des Signals S2 verzerrten Signale S3 und S4 ergeben. Zur Ausbalancierung der Signalamplitudenverhältnisse zwischen den komplementär verzerrten Signalen S3 und S4 wird die Verstärkung des Verstärkers 4 entsprechend eingestellt, beispielsweise auf den Verstärkungsfaktor 2 (+ 6 dB).

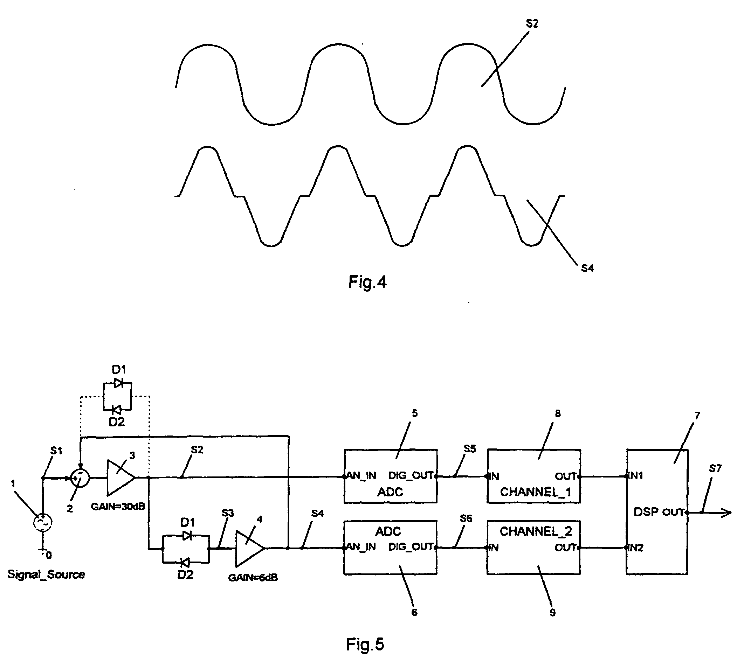

Die komplementär verzerrten Signale S2 und S4 sind (rein qualitativ, d.h., ohne Berücksichtigung einer eventuellen Skalierung) mit ihren Signalverläufen in Fig. 4 veranschaulicht. Hieraus erkennt man, daß das Signal S4 unterhalb der Schwellenspannung der antiparallel geschalteten Dioden D1, D2 im zweiten Signalweg keine Informationen trägt, so daß auch das entsprechende digitalisierte Signal S6 am Ausgang des Analog-Digital-Wandlers 6 keine Nutzinformation, sondern nur das Eigenrauschen enthält. Dieses Eigenrauschen kann durch die Verarbeitung der digitalisierten Signale S5, S6 im digitalen Signalprozessor 7 völlig rückwirkungsfrei dadurch unterdrückt werden, in daß das digitale Signal S6 für diesen Fall abgeschaltet bzw. nicht zur Bildung des digitalen Ausgangssignals S7 verwendet wird.

Die Verstärkung des Verstärkers 3 kann beliebig gewählt werden, um das Rauschen des Analog-Digital-Wandlers 5 soweit unter das Rauschen des analogen Eingangssignals abzusenken, daß keine nennenswerte Rauschaddition zwischen analogem und digitalem Rauschen stattfindet. Dies ergibt sich daraus, daß bei der Addition der digitalen Signale S5 und S6 das Signal S5 am Ausgang des Analog-Digital-Wandlers 5 unter Einbeziehung der störenden digitalen Rauschanteile um die Verstärkung des Verstärkers 3 vermindert wird.

Es versteht sich, daß das nicht-lineare Netzwerk im zweiten Signalweg vor dem Eingang des Verstärkers 4 auch anders als durch antiparallel geschaltete Dioden verwirklicht werden kann. In jedem Falle ist das nicht-lineare Netzwerk hinsichtlich der Übertragungscharakteristik und Toleranzen völlig unkritisch, da durch die lineare Einspeisung des verzerrten Signals S4 in den Addierer 2 automatisch das richtige komplementär verzerrte Signal S3 entsteht. Hinsichtlich der gewünschten Amplitudenverhältnisse zwischen den Signalen S3 und S4 wirkt sich die Erzeugung des verzerrten Signals S4 aus dem Signal S3 und Einspeisung des Signals S4 in Sinne einer Gegenkopplung in den Addierer 2 vorteilhaft aus, da hierdurch die stabilisierende Wirkung eines geschlossenen Regelkreises entsteht.

Grundsätzlich ist die Durchführung des Verfahrens jedoch auch in der Weise möglich, daß das verzerrte Signal S4 direkt aus dem linearen Eingangssignal S1 gewonnen wird. Eine solche Schaltung ist in Fig. 3 veranschaulicht. Bei dieser Variante wird dem nichtlinearen Netzwerk (z.B. antiparallel geschaltete Dioden D1, D2) vor dem Verstärker 4 das Eingangssignal S1 direkt zugeführt.

Insgesamt ergeben sich bei dem erfindungsgemäßen Verfahren folgende vorteilhafte Eigenschaften:
- Der hochauflösende erste Signalweg mit dem Verstärker 3 und dem Analog-Digital-Wandler 5 ist stets aktiv, d.h., er wird nicht abgeschaltet oder ausgeblendet und trägt daher zu jedem Zeitpunkt zur Bildung des digitalen Ausgangssignals S7 bei.
- Die Auflösung als Maß der differentiellen Verstärkung des Verstärkers 3 wird ab dem Einsatzpunkt des nicht-linearen Netzwerks, im Beispielsfalle von Fig. 2 oder 3 ab der Schwellenspannung der antiparallel geschalteten Dioden D1/D2 reduziert. Diese Auflösungsreduktion erfolgt mit steigender Amplitude langsam, kontinuierlich sowie automatisch nur um das augenblicklich minimal notwendige Maß, so daß im Bereich der normalen Arbeitsdynamik keine oder nur eine unwesentliche Auflösungsreduktion erfolgt. Damit wird jeder Punkt in der Signalamplitude mit der theoretisch möglichen Auflösung übertragen.
- Selbst im Falle der Grenzaussteuerung tragen beide Signalwege zur Darstellung des Nutzsignals bei, was zu einer höheren Auflösung und zu geringerem Gesamtrauschen führt.
- Das Schalten des digitalisierten Signals S6 am Ausgang des Analog-Digital-Wandlers 6 zur Unterdrückung des dort vorhandenen Rauschens ist unkritisch bzw. rückwirkungsfrei, da kein Nutzsignal geschaltet wird. Die Schaltinformation kann leicht und rechtzeitig aus beiden Signalwegen, vorzugsweise aus dem Nutzsignal des stets aktiven ersten Signalweges gewonnen werden.
- Die Zusammensetzung der digitalisierten Signale S5, S6 im digitalen Signalprozessor 7 erfolgt rein zahlenmäßig und unverfälscht von Interpolationen, was zu geringen Verzerrungen des digitalen Ausgangssignals S7 führt. Irgendwelche Überblendalgorithmen, gegebenenfalls mit Interpolationscharakter, werden in dem digitalen Signalprozessor 7 nicht benötigt.
- Beide Analog-Digital-Wandler 5,6 werden im gesamten Dynamikbereich nicht übersteuert, so daß die Dezimationsfilter in den Analog-Digital-Wandlern zu jedem Zeitpunkt mathematisch korrekte Daten enthalten.

Es ist bei dem erfindungsgemäßen Verfahren grundsätzlich möglich, das Eingangssignal S1 auch auf mehr als zwei Signalwege aufzuteilen, wobei dann das komplementär verzerrte Signal S4 aus mehreren Teilsignalen entsprechend der größeren Anzahl von Signalwegen gebildet wird. Diese mehreren Teilsignale, die in der Summe dem verzerrten Signal S4 bzw. dem komplementär verzerrten Anteil des Signals S2 entsprechen, werden einer entsprechenden Anzahl von Analog-Digital-Wandlern zugeführt.

Diese Teilsignale werden in gleicher Weise erzeugt wie das Signal S4 im Falle der Schaltung nach Fig. 2 oder 3, gegebenenfalls mit unterschiedlicher Übertragungscharakteristik der nicht-linearen Netzwerke zur Erzeugung dieser Teilsignale.

Das erfindungsgemäße Verfahren kann, wie an Hand von Fig.5 veranschaulicht ist, auch allgemein zur Dynamikerweiterung für beliebige Signalübertragungen verwendet werden. Für diesen Fall werden beliebige Übertragungsstrecken oder Speichermedien mit natürlich begrenzter Dynamik (= Kanäle 8, 9) zwischen den Analog-Digital-Wandlern 5, 6 und dem empfangsseitig vorhandenen Signalprozessor 7 vorgesehen. Falls die Kanäle 8, 9 mit eigenen Analog-Digital-Wandlern ausgestattet sind, können natürlich die Analog-Digital-Wandler 5, 6 entfallen. Hierbei spielt die Übertragungscharakteristik der einzelnen Kanäle 8, 9 solange keine Rolle, als beide Kanäle 8, 9 weitgehend gleiches Verhalten zeigen.

## Patentansprüche

1. Verfahren zum Umwandeln eines analogen Eingangssignals (S1) in ein digitales Ausgangssignal (S7), bei dem
- aus dem analogen Eingangssignal (S1) unterschiedliche erste und zweite analoge Teilsignale (S2, S4) abgeleitet werden,
- die ersten und zweiten analogen Teilsignale (S2, S4) jeweils einer Analog-Digital-Wandlung (5, 6) unterzogen werden,
- die so gebildeten digitalisierten Teilsignale (S5, S6) einem digitalen Signalprozessor (7) oder äquivalent wirkenden digitalen Schaltkreisen zugeführt werden, welcher das digitale Ausgangssignal (S7) aus den digitalisierten Teilsignalen (S5, S6) erzeugt,
**dadurch gekennzeichnet, dass** das zweite analoge Teilssignal (S4) derart verzerrt ist, dass es unterhalb eines Schwellenpegels im wesentlichen keine Nutzinformation aus dem Eingangssignal (S1) enthält, und dass das erste analoge Teilsignal (S2) durch vorzeichenrichtige Addition des Eingangssignals (S1) und des zweiten analogen Teilsignals (S4) gebildet wird, so dass das daraus resultierende erste analoge Teilsignal (S2) eine bezüglich des zweiten analogen Teilsignals (S4) komplementär verzerrte Signalform aufweist.

2. Verfahren nach Anspruch 1, **dadurch gekennzeichnet, dass** zur Verzerrung des zweiten analogen Teilsignals (S4) ein Netzwerk mit nicht-linearer Übertragungscharakteristik vorgesehen ist.

3. Verfahren nach Anspruch 1, **dadurch gekennzeichnet, dass** zur Verzerrung des zweiten analogen Teilsignals (S4) antiparallel geschaltete Dioden (D1, D2) vorgesehen sind.

4. Verfahren nach Anspruch 2 oder 3, **dadurch gekennzeichnet, dass** dem nicht-linearen Netzwerk bzw. den antiparallel geschalteten Dioden (D1, D2) das erste analoge Teilsignal (S2) zugeführt wird.

5. Verfahren nach Anspruch 2 oder 3, **dadurch gekennzeichnet, dass** dem nicht-linearen Netzwerk bzw. den antiparallel geschalteten Dioden (D1, D2) das analoge Eingangssignal (S1) zugeführt wird.

6. Verfahren nach einem der Ansprüche 1 bis 5, **dadurch gekennzeichnet, dass** die ersten und zweiten digitalisierten Teilsignale (S5, S6) im Signalprozessor (7) vorzeichenrichtig und amplitudenrichtig unter Berücksichtigung von Verstärkungen der ersten und zweiten analogen Teilsignale (S2, S4) zur Bildung des unverzerrten digitalen Ausgangssignals (S7) zusammengesetzt werden.

7. Verfahren nach einem der Ansprüche 1 bis 6, **dadurch gekennzeichnet, dass** das zweite digitalisierte Teilsignal (S6) im Signalprozessor (7) abgeschaltet bzw. nicht zur Bildung des digitalen Ausgangssignals (S7) verwendet wird, solange es keine Nutzinformation aus dem Eingangssignal (S1) enthält.

8. Verfahren nach Anspruch 7, **dadurch gekennzeichnet, dass** die Schaltinformation zum Abschalten des zweiten digitalisierten Teilsignals (S6) durch Vergleich des zweiten digitalisierten Teilsignals (S6) mit einem Referenzwert gewonnen wird.

9. Verfahren nach Anspruch 7, **dadurch gekennzeichnet, dass** die Schaltinformation zum Abschalten des zweiten digitalisierten Teilsignals (S6) durch Vergleich des ersten digitalisierten Teilsignals (S5) mit einem Referenzwert gewonnen wird.

10. Verfahren nach einem der Ansprüche 1 bis 9, **dadurch gekennzeichnet, dass** die ersten und zweiten digitalisierten Teilsignale (S5, S6) über Signalübertragungstrecken oder Speichermedien (Kanäle 8, 9) geführt werden, und dass die übertragenen bzw. ausgelesenen ersten und zweiten digitalisierten Teilsignale (S5, S6) auf der Empfangsseite der Signalübertragungsstrecken bzw. Speichermedien dem digitalen Signalprozessor (7) zugeführt und dort zu dem digitalen Ausgangsignal (S7) zusammengesetzt werden.

## Claims

1. Method of converting an analog input signal (S1) into a digital output signal (S7), in which
- different first and second analog part-signals (S2, S4) are derived from the analog input signal (S1),
- the first and second analog part-signals (S2, S4) are each subjected to an analog-to-digital conversion (5, 6),
- the digitised part-signals (S5, S6) formed in this way are fed to a digital signal processor (7), or to digital circuits acting in an equivalent way, which processor generates the digital output signal (S7) from the digitised part-signals (S5, S6),
**characterised in that** the second analog part-signal (S4) is distorted in such a way that, below a threshold level, it contains substantially no useful information from the input signal (S1), and **in that** the first analog part-signal (S2) is formed by adding the input signal (S1) and the second analog part-signal (S4) with the correct sign, which means that the first analog sub-signal (S2) resulting therefrom is of a form which is distorted in a complementary way relative to the second analog part-signal (S4).

2. Method according to claim 1, **characterised in that** a network having a non-linear transfer characteristic is provided for distorting the second analog part-signal (S4).

3. Method according to claim 1, **characterised in that** that diodes (D1, D2) connected in anti-parallel are provided for distorting the second analog part-signal (S4).

4. Method according to claim 2 or 3, **characterised in that** the first analog part-signal (S2) is fed to the non-linear network or the diodes (D1, D2) connected in anti-parallel.

5. Method according to claim 2 or 3, **characterised in that** the analog input signal (S1) is fed to the non-linear network or the diodes (D1, D2) connected in anti-parallel.

6. Method according to one of claims 1 to 5, **characterised in that** the first and second digitised part-signals (S5, S6) are combined in the signal processor (7) to form the undistorted digital output signal (S7) with the correct sign and at the correct amplitude with due allowance for the amplifications of the first and second part-signals (S2, S4).

7. Method according to one of claims 1 to 6, **characterised in that** the second digitised part-signal (S6) is switched off or not used for forming the digital output signal (S7) in the signal processor (7) as long as it does not contain any useful information from the input signal (S1).

8. Method according to claim 7, **characterised in that** the switching information for switching off the second digitised part-signal (S6) is obtained by comparing the second digitised part-signal (S6) with a reference value.

9. Method according to claim 7, **characterised in that** the switching information for switching off the second digitised sub-signal (S6) is obtained by comparing the first digitised part-signal (S5) with a reference value.

10. Method according to one of claims 1 to 9, **characterised in that** the first and second digitised part-signals (S5, S6) are fed via signal-transmission paths or storage media (channels 8, 9), and **in that** the first and second digitised part-signals (S5, S6) which are transmitted or read out are fed, at the reception end of the signal transmission paths or storage media, to the digital signal processor (7) and are there combined to form the digital output signal (S7).

## Revendications

1. Procédé pour convertir un signal d'entrée analogique (S1) en un signal de sortie numérique (S7), dans lequel
- on dérive du signal d'entrée analogique (S1) des premier et second signaux partiels analogiques (S2, S4) différents,
- on soumet les premier et second signaux partiels analogiques à une conversion analogique/numérique (5, 6) respective,
- les signaux partiels (S5, S6) ainsi numérisés sont amenés à un processeur de signal (7) numérique ou à un circuit numérique fonctionnant de façon équivalente, qui produit le signal de sortie numérique (S7) à partir des signaux partiels (S5, S6) numérisés,
**caractérisé en ce que** le second signal partiel analogique (S4) est déformé de façon telle, qu'en dessous d'un niveau de seuil, il ne contient pas, pour l'essentiel, d'informations utiles sur le signal d'entrée (S1), et **en ce que** le premier signal partiel analogique (S2) est formé par addition avec le signe correct du signal d'entrée (S1) et du second signal partiel analogique (S4), de sorte que le premier signal partiel analogique (S2) qui en résulte présente une forme de signal déformé complémentaire par rapport au second signal partiel (S4) analogique.

2. Procédé selon la revendication 1, **caractérisé en ce que** pour déformer le second signal partiel analogique (S4), on prévoit un moyen de circuit à caractéristique de transmission non linéaire.

3. Procédé selon la revendication 1, **caractérisé en ce que** pour déformer le second signal partiel analogique (S4), on prévoit des diodes montées de façon anti-parallèle (D1, D2).

4. Procédé selon la revendication 2 ou 3, **caractérisé en ce que** le premier signal partiel analogique (S2) est amené au moyen de circuit non linéaire ou aux diodes montées de façon anti-parallèle (D1, D2).

5. Procédé selon la revendication 2 ou 3, **caractérisé en ce que** le signal d'entrée analogique est amené au moyen de circuit non linéaire ou aux diodes montées de façon anti-parallèle (D1, D2).

6. Procédé selon l'une des revendications 1 à 5,
**caractérisé en ce que** les premier et second signaux partiels numérisés (S5, S6) sont combinés dans le processeur de signal (7) avec le signe correct et l'amplitude correcte en prenant en compte les amplifications des premier et second signaux partiels analogiques (S2, S4) pour former le signal de sortie numérique (S7) non déformé.

7. Procédé selon l'une des revendications 1 à 6,
**caractérisé en ce que** le second signal partiel numérisé (S6) est interrompu dans le processeur de signal (7) ou n'est pas utilisé pour former le signal de sortie numérique (S7), tant qu'il ne contient pas d'information utile sur le signal d'entrée (S1).

8. Procédé selon la revendication 7, **caractérisé en ce que** l'information de commutation pour interrompre le premier signal partiel numérisé (S6) est obtenue par comparaison du second signal partiel numérisé (S6) avec une valeur de référence.

9. Procédé selon la revendication 7, **caractérisé en ce que** l'information de commutation pour interrompre le second signal partiel numérisé (S6) est obtenue par comparaison du premier signal partiel numérisé (S5) avec une valeur de référence.

10. Procédé selon l'une des revendications 1 à 9, **caractérisé en ce que** le premier et le second signal partiel numérisé (S5, S6) sont transmis par des chemins de transmission de signal ou par des médias d'enregistrement (canaux 8, 9), et **en ce que** les premier et second signaux partiels numérisés (S5) qui sont transmis ou lus, sont amenés au processeur de signal numérique (7) par le côté d'entrée des chemins de transmission de signal ou des médias d'enregistrement et, là, sont combinés au signal de sortie numérique (S7).
